# EUROPEAN PATENT SPECIFICATION

(11) **EP 2 004 746 B1**
(45) Date of publication and mention of the grant of the patent: **01.08.2018**
(21) Application number: 06739912.1
(22) Date of filing: 29.03.2006
(51) Int. Cl.: C08L 23/22, C09J 201/00

(54) **RADIATION-CURABLE RUBBER ADHESIVE/SEALANT**
STRAHLUNGSHÄRTBARER KAUTSCHUK-KLEBSTOFF/DICHTSTOFF
MATERIAU D'ETANCHEITE/ADHESIF A BASE DE CAOUTCHOUC DURCISSABLE PAR RAYONNEMENTS

(43) Date of publication of application: 24.12.2008
(73) Proprietor: Henkel AG & Co. KGaA, 40589 Düsseldorf (DE)
(72) Inventor: CAO, Jie, Hillsborough, New Jersey 08844 (US); HERR, Donald, Doylestown, Pennsylvania 18901 (US)
(86) International application number: PCT/US2006/011442
(87) International publication number: WO 2007/111607

(56) References cited:
- EP-A- 1 538 170
- WO-A-03/002684
- WO-A-2006/107802
- US-A- 5 171 760
- US-B2- 6 706 779

## Description

### FIELD OF THE INVENTION

This invention relates to electronic and optoelectronic devices, according to claims 1 to 5, such as organic light emitting diodes.

### BACKGROUND OF THE INVENTION

It is well known that a variety of packaged electronic devices require moisture protection to achieve a specified operating or storage lifetime. In particular, the relative humidity within the encapsulated packages of highly moisture-sensitive electronic/optoelectronic devices, such as organic light-emitting devices (OLED), polymer light-emitting devices, charge-coupled device (CCD) sensors, micro-electro-mechanical sensors (MEMS), liquid crystal devices (LCD), and electrophoretic devices, must be controlled below a certain level, particularly below 1000 ppm or even in some cases below 100 ppm, in order to fully protect the organic light-emitting layers, electrodes, or other moisture-sensitive components.

There are several approaches used in the prior art to protect encapsulated or packaged devices from water. These techniques do not always work: organic sealants may not meet the stringent moisture permeation requirement; moisture impermeable solder sealants may have melting temperatures that are too high for temperature sensitive devices; and desiccant packages attached on the device inner wall may block light emission out of the device, a particular problem for top-emitting organic light-emitting diodes.

### BRIEF DESCRIPTION OF THE DRAWINGS

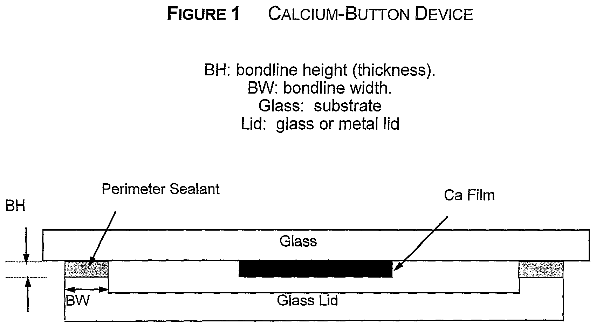

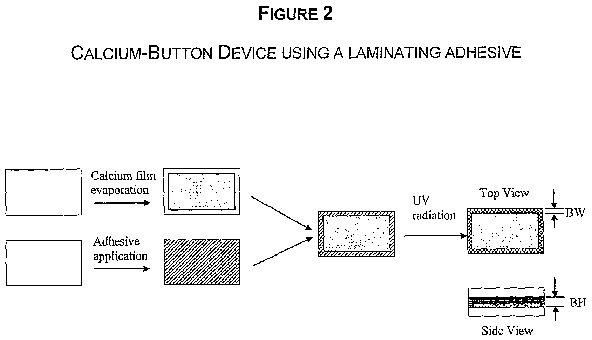

FIGURE 1 is a perimeter sealed calcium button device. Figure 2 is a calcium button device using a laminating adhesive.

### SUMMARY OF THE INVENTION

This invention is an electronic or optoelectronic device, according to claims 1 to 5, disposed on a substrate and encapsulated with a lid in which the lid and substrate are bonded together with a sealant/adhesive disposed on the whole area between or along the perimeter the substrate and the lid, the sealant/adhesive comprising a radiation-curable adhesive/sealant composition comprising: a) a radiation-curable barrier rubber resin not containing siloxane functionality, b) a radiation-curable resin diluent c) a photoinitiating system comprising one or more photoinitiators selected from diaryliodonium salts and triarylsulfonium salts and optionally one or more photosensitizers selected from isopropylthioxanthone (ITX) and chloropropoxythioxanthone (CPTX), wherein the radiation-curable barrier rubber resin is an olefin-terminal polyisobutylene, polyisobutylene acrylate, polyisobutylene epoxy, polyisobutylene vinyl ether, butyl rubber, epoxidized butyl rubber, acrylated butyl rubber, maleated butyl rubber or mercaptan functional butyl rubber, and wherein in a radiation curable resin diluent is bisphenol F diglycidyl ether, bisphenol A diglycidyl ether, tetramethylbiphenyldiglycidyl ether, resorcinol diglycidyl ether, hydrogenated bisphenol A diglycidylether, cyclohexanedimethylol diglycidyl ether, cycloaliphatic epoxy resin, oxetane resin, cyclohexanedimethylol divinyl ether, dodecyl vinyl ether, hexane diol diacrylate, trimethylolpropane triacrylate, cyclohexanedimethylol diacrylate, dicyclo-pentadienedimethylol diacrylate, tris(2-hydroxyethyl)isocyanurate triacrylate, poly(butadiene)dimethacrylate, bisphenol A based acrylated epoxy, maleimide resins have the structures of claim 1 in which (C₃₆) represents a hydrocarbon moiety having 36 carbons, which can be a straight or branched chain, with or without cyclic structures and pentaerythritoltetrakis(3-mercaptopropionate)/triallyl-isocyanurate, diallylchlorendate or tetraallylbisphenol A.

### DETAILED DESCRIPTION OF THE INVENTION

In this specification the term radiation curing refers to the cure of a resin or resin/filler system through exposure to actinic radiation. Actinic radiation is electromagnetic radiation that induces a chemical change in a material, and for purposes within this specification and claims will include electron-beam curing. In most cases, such radiation is ultraviolet (UV) or visible light. The initiation of this cure is achieved through the use of an appropriate photoinitiator.

Suitable resins are polyisobutylenes or butyl rubbers containing functional groups that are radiation curable (hereinafter, barrier rubber resins, rubber resins, or sealant/adhesives). Exemplary materials are olefin-terminal polyisobutylene, polyisobutylene acrylates, polyisobutylene epoxies, polyisobutylene vinyl ethers, butyl rubber, and butyl rubber derivatives (such as, epoxidized butyl rubber, acrylated butyl rubber, maleated butyl rubber, mercaptan functional butyl rubber, and like compounds). Representative polyisobutylene acrylates are described in U.S. patent 5,171,760 issued to Edison Polymer Innovation Corp., U.S. patent 5,665,823 issued to Dow Corning Corp., and Polymer Bulletin, Vol. 6, pp. 135-141 (1981), T.P. Liao and J. P. Kennedy. Representative polyisobutylene epoxy materials are described in Polymer Material Science and Engineering, Vol. 58, pp. 869 (1988) and in the Journal of Polymer Science, Part A, Polymer Chemistry, Vol. 28 pp. 89 (1990), J. P. Kennedy and B. Ivan. Representative polyisobutylene vinyl ethers are described in Polymer Bulletin, Vol. 25, pp. 633 (1991), J. P. Kennedy and coworkers, and in U.S. patent 6,054,549, 6,706,779B2 issued to Dow Corning Corp. Representative radiation curable butyl rubbers are described in RadTech North America proceedings, pp. 77, (1992), N.A. Merrill, I.J. Gardner and V.L. Hughes.

These rubber resins contain reactive functionalities that are curable by radiation. Such reactive functionalities include, but are not limited to, those selected from the group consisting of glycidyl epoxy, aliphatic epoxy, cycloaliphatic epoxy; oxetane; acrylate, methacrylate, itaconate; maleimide; vinyl, propenyl, crotyl, allyl, and propargyl ether and thio-ethers of those groups; maleate, fumarate, and cinnamate esters; styrenic; acrylamide and methacrylamide; chalcone; thiol; allyl, alkenyl, and cycloalkenyl groups.

The radiation-curable reactive diluent will be any of the radiation-curable resins known to those with experience in the field of UV curable materials and filled polymer composites. The resins may be small molecules, oligomers, or polymers, and will be chosen by the practitioner as appropriate for the end use application. If fillers are used, the particular filler chosen may also be varied depending on the rheological requirements needed for a particular optoelectronic or electronic device. The cure mechanism also may vary (cationic, radical, etc.), to suit the particular resin and filler system chosen.

The backbone of the radiation-curable resins is not limited. The reactive functionalities on the resins will be those reactive to the initiators or catalysts formed by exposure to radiation and include, but are not limited to, epoxies, selected from glycidyl epoxy, aliphatic epoxy, and cycloaliphatic epoxy; oxetane; acrylate and methacrylate; itaconate; maleimide; vinyl, propenyl, crotyl, allyl, and propargyl ether and thio-ethers of those groups; maleate, fumarate, and cinnamate esters; styrenic; acrylamide and methacrylamide; chalcone; thiol; allyl, alkenyl, and cycloalkenyl groups.

Suitable cationic polymerizable radiation-curable resins include epoxies, oxetanes, vinyl ethers, and propenyl ethers. Representative epoxy resins are glycidyl ethers and cycloaliphatic epoxies, which are commercially available from a number of sources known to those skilled in the art.

Representative aromatic liquid glycidyl ethers include bisphenol F diglycidyl ether (sold under the trade name Epikote 862 from Resolution Performance Products) or bisphenol A diglycidyl ether (sold under the trade name Epikote 828 from Resolution Performance Products). Representative solid glycidyl ethers include tetramethylbiphenyldiglycidyl ether (sold under the trade name RSS 1407) and resorcinol diglycidyl ether (sold under the trade name Erisys RDGE® available from CVC Specialty Chemicals, Inc.). Other aromatic glycidyl ethers are commercially available under the trade names Epon 1031, Epon 164, and SU-8 available from Resolution Performance Products.

Representative non-aromatic glycidyl epoxy resins include an hydrogenated bisphenol A diglycidylether (sold under the trade name EXA-7015 from Dainippon Ink & Chemicals) or cyclohexanedimethylol diglycidyl ether available from Aldrich Chemical Co.

Representative cycloaliphatic epoxy resins include ERL 4221 and ERL 6128 available from Dow Chemical Co. A representative oxetane resin is OXT-121 available from Toagosei. Representative vinyl ether molecules include cyclohexanedimethylol divinyl ether (Rapicure-CHVE), tripropylene glycol divinyl ether (Rapicure-DPE-3) or dodecyl vinyl ether (Rapicure-DDVE) all available from International Specialty Products. Analogous vinyl ethers are also available from BASF.

Suitable radically polymerizable radiation-curable resins include acrylates, maleimides, or thiol-ene based resins. In many cases, combinations of these three resins can be utilized to tailor the properties of the sealant/adhesive material.

Representative acrylate resins include hexane diol diacrylate, trimethylolpropane triacrylate, cyclohexanedimethylol diacrylate, dicyclo-pentadienedimethylol diacrylate, tris(2-hydroxyethyl)isocyanurate triacrylate, poly(butadiene)dimethacrylate, and bisphenol A based acrylated epoxy. Such resins are commercially available from Sartomer and UCB Chemicals.

The liquid maleimide resins of claim 1 are described, for example, in US patents 6,265,530, 6,034,194, and 6,034,195, and in present claims 1 to 5 in particular maleimide resins have the structures 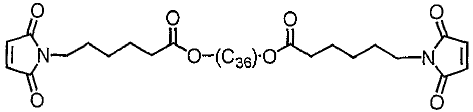 in which (C₃₆) represents a hydrocarbon moiety having 36 carbons, which can be a straight or branched chain, with or without cyclic structures; 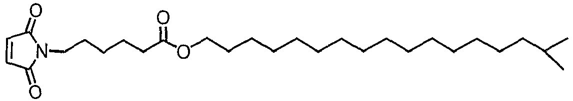 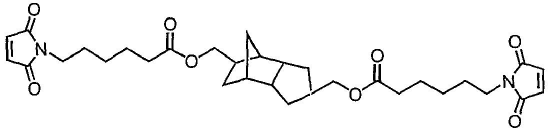 and

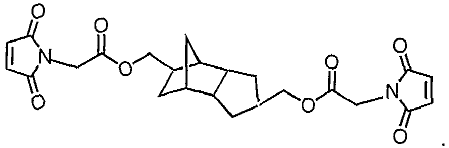

And further in claim 1, thiol-ene radically photopolymerizable systems include the pentaerythritoltetrakis(3-mercaptopropionate)/triallyl-isocyanurate system. Other useful thiols include those described in US patent 5,919,602 issued to MacDermid Acumen, Inc. Other useful polyenes include diallylchlorendate (sold under the trade name BX-DAC) and tetraallylbisphenol A, both available from Bimax, Inc.

Additional suitable radiation-curable resins, and photoinitiators for those resins, will include those found in literature sources such as Fouassier, J-P., Photoinitiation, Photopolymerization and Photocuring Fundamentals and Applications 1995, Hanser/Gardner Publications, Inc., New York, NY.

The selection of a photoinitiating system for the inventive radiation curable barrier materials is familiar to those skilled in the art of radiation curing. The photoinitiating system will comprise one or more photoinitiators and optionally one or more photosensitizers. The selection of an appropriate photoinitiator is highly dependent on the specific application in which the barrier sealant is to be used. A suitable photoinitiator is one that exhibits a light absorption spectrum that is distinct from that of the resins, fillers, and other additives in the radiation curable system.

If the sealant must be cured through a cover or substrate, the photoinitiator will be one capable of absorbing radiation at wavelengths for which the cover or substrate is transparent. For example, if a barrier sealant is to be cured through a sodalime glass coverplate, the photoinitiator must have significant UV absorbance above ca. 320 nm. UV radiation below 320 nm will be absorbed by the sodalime glass coverplate and not reach the photoinitiator. In this example, it would be beneficial to include a photosensitizer with the photoinitiator into the photoinitiating system, to augment the transfer of energy to the photoinitiator.

For cationically photopolymerizable systems, and according to claims 1 to 5, the most useful photoinitiators are diaryliodonium salts and triarylsulfonium salts *containing* anions such as, but not limited to fluorinated anions, such as BF₄⁻, PF₆⁻, AsF₆⁻ or SbF₆⁻. Commercially available representative iodonium salts include PC2506 (Polyset), UV9380C (GE silicones), and Rhodorsil 2074 (Rhodia). Other suitable cationic photoinitiators are sulfonium salts, a representative sulfonium salt being UVI-6974 (Dow Chemical). Depending on the application, photosensitizers such as isopropylthioxanthone (ITX) and chloropropoxythioxanthone (CPTX), both available from Aldrich and other vendors, are useful in combination with iodonium salt photoinitiators. Radical photoinitiators are available from Ciba Specialty Chemicals and other vendors. Representative useful radical photointiators from Ciba include Irgacure 651, Irgacure 819, and Irgacure 907. Other photoinitiators are disclosed in Ionic Polymerizations and Related processes, 45-60, 1999, Kluwer Academic Publishers; Netherlands; J.E. Puskas et al. (eds.). Photoinitiators will be used in amounts ranging from 0.1 wt% to 10 wt%.

Inorganic fillers may be used to improve the material properties or the rheology of the compositions. There are many such fillers that are useful in the inventive UV curable sealants/adhesives. Representative fillers include, but are not limited to, ground quartz, fused silica, amorphous silica, talc, glass beads, graphite, carbon black, alumina, clays, mica, aluminum nitride, and boron nitride. Metal powders and flakes consisting of silver, copper, gold, tin, tin/lead alloys, and other alloys also are suitable fillers for conductive applications. Organic filler powders such as poly-(tetrachloroethylene), poly(chlorotrifluoroethylene), poly(vinylidene chloride) may also be used. The type and amount of such fillers suitable for use in radiation-curable compositions is within the expertise of the practitioner skilled in the art. Generally, however, such fillers will be present in amounts ranging from 1 wt% to 90 wt%.of the total formulation.

Yet another item of the present invention relates to an electronic or optoelectronic device, according to claims 3 to 5, wherein the device is an electrophoretic or an OLED device.

### EXAMPLES

The moisture barrier performance of sealants can be evaluated by a test known as the Ca-button test, in which the time is measured for which it takes a thin film of calcium metal encapsulated into a device to decay to a calcium salt through reaction with water. The longer the lifetime of the calcium metal film before decay, the lower the moisture permeation into the device and the better the sealant/adhesive protecting the device.

A Ca-button device as used in these examples is shown in Figure 1, in which BH is the bondline height (thickness) of the perimeter sealant/adhesive; BW is the bondline width of the perimeter sealant/ adhesive; glass is the substrate on which the calcium metal film is disposed; and lid is the glass or metal lid used to encapsulate the resultant device.

The device was assembled in a N₂-filled glove box. A thin Ca film was first evaporated on a glass substrate (26 mm×15.5 mm×1.1 mm) (L×W×H) by vapor deposition to a thickness of 100 nm and a geometry of 23 mm×12.5 mm (L×W). The BW of sealant/adhesive is 1.5 mm. The Ca film was encapsulated by a lid using a sealant/adhesive that was dispensed on whole area of the lid. The sealant joint was cured by a UV-radiation spot cure unit to bind the substrate and the lid together with a dose of 3.0 J/cm² of UV-A radiation.

The sealed Ca-button device was placed in an environment controlled to 65°C/80%RH (relative humidity). Initially, the calcium metal film is a metallic mirror capable of reflecting light. Upon exposure to moisture the metallic film turns to a calcium salt, becomes transparent, and no longer reflects. The calcium film in the button device was continuously monitored by a proprietary reflectance unit in order to identify the time when the calcium metal film was fully decayed. Since moisture can only permeate into the enclosed device through the exposed sealant layer, the lifetime of a Ca-button can be used to evaluate moisture barrier performance.

The sealed Ca-button device was placed in an environment controlled to 65°C/80%RH (relative humidity). Initially, the calcium metal film is a metallic film. Upon exposure to moisture permeated through the edge of seal, the metallic film turns to a calcium salt, becomes transparent. Thus, the area of the metallic film becomes smaller vs. time. The area of the calcium film in the button device was periodically monitored and measured in order to identify the time when the area of the calcium metal film reached to 70% of its original area, which is defined as Ca-button lifetime. Since moisture can only permeate into the enclosed device through the exposed sealant layer, the lifetime of a Ca-button can be used to evaluate moisture barrier performance.

Example sealant/adhesive compositions were prepared for water permeability testing using the Ca-button test by mixing the composition components in a FlackTek Speedmixer™ and degassed before application to the Ca-button device. The compositions were applied to the Ca-button device in a N₂ filled glove box to avoid moisture absorption by the Ca-button and desiccants.

EXAMPLE. Formulations were prepared as recited above to contain a radiation-curable rubber resin. As shown in Table 1, formulation 1(a) contained a polyisobutylene diacrylate resin (Mₙ=5300, 70 part by weight), which was prepared from the method developed in Kennedy's group (T.P. Liao and J. P. Kennedy, Polymer Bulletin, Vol. 6, pp. 135-141 (1981)), a diacrylate resin (Sartomer SR833S, 30 part by weight), and a radical photoinitiator (Irgacure 651, 0.3 part by weight). The water permeability is 4.5 g·mil/100in²·day measured by Mocon Permeatran 3/33 at 50°C/100%RH. Formulation 1(b) contained a liquid rubber resin, mostly a styrene-butadienestyrene copolymer with acrylic side-chain addition. The permeability for formulation 1(b) is 18 g·mil/100in²·day. As shown in Table 1, formulation 1(a) showed better Ca-button lifetime than formulation 1(b), implying that the better resin moisture barrier performance of the resin containing the polyisobutylene diacrylate resin improves device lifetime.

**Table 1: Sealant 1(a) (barrier rubber), 1(b) (non-barrier rubber):**

| Component | Parts by Weight | |
|---|---|---|
| | 1-a | 1-b |
| Polyisobutylene diacrylate (Mₙ=5300) | 70 | 0 |
| Sartomer SR833S | 30 | 0 |
| Acrylated polyisoprene | 0 | 99.5 |
| Irgarcure 651 | 0.3 | 0.5 |
| Permeability (g·mil/100in²·day) at 50°C/100%RH | 4.5 | 18 |
| Bondline thickness (mil) | 1.3 | 1.3 |
| Ca-button lifetime (hrs) | 88 | 4.5 |

## Claims

1. An electronic or optoelectronic device, disposed on a substrate and encapsulated with a lid in which the lid and substrate are bonded together with a sealant/adhesive disposed on the whole area between the substrate and the lid, the sealant/adhesive comprising a radiation-curable adhesive/sealant composition comprising:
a) a radiation-curable barrier rubber resin not containing siloxane functionality,
b) a radiation-curable resin diluent
c) a photoinitiating system comprising one or more photoinitiators selected from diaryliodonium salts and triarylsulfonium salts and optionally one or more photosensitizers selected from isopropylthioxanthone (ITX) and chloropropoxythioxanthone (CPTX), wherein the radiation-curable barrier rubber resin is an olefin-terminal polyisobutylene, polyisobutylene acrylate, polyisobutylene epoxy, polyisobutylene vinyl ether, butyl rubber, epoxidized butyl rubber, acrylated butyl rubber, maleated butyl rubber or mercaptan functional butyl rubber, and wherein in a radiation curable resin diluent is bisphenol F diglycidyl ether, bisphenol A diglycidyl ether, tetramethylbiphenyldiglycidyl ether, resorcinol diglycidyl ether, hydrogenated bisphenol A diglycidylether, cyclohexanedimethylol diglycidyl ether, cycloaliphatic epoxy resin, oxetane resin, cyclohexanedimethylol divinyl ether, dodecyl vinyl ether, hexane diol diacrylate, trimethylolpropane triacrylate, cyclohexanedimethylol diacrylate, dicyclo-pentadienedimethylol diacrylate, tris(2-hydroxyethyl)isocyanurate triacrylate, poly(butadiene)dimethacrylate, bisphenol A based acrylated epoxy, maleimide resins having the structures 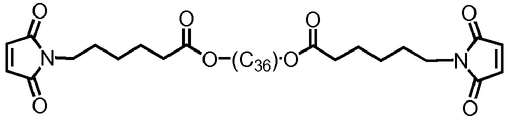 in which (C₃₆) represents a hydrocarbon moiety having 36 carbons, which can be a straight or branched chain, with or without cyclic structures; 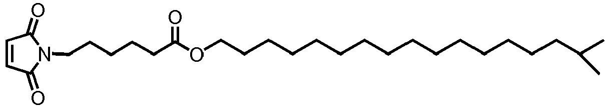 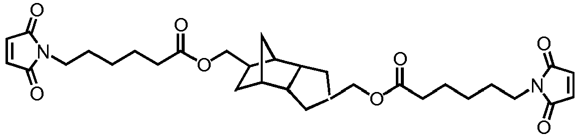 and 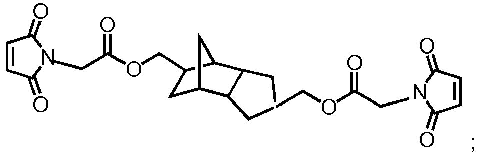 pentaerythritoltetrakis(3-mercaptopropionate)/triallyl-isocyanurate, diallylchlorendate or tetraallylbisphenol A.

2. An electronic or optoelectronic device, disposed on a substrate and encapsulated with a lid in which the lid and substrate are bonded together with a sealant/adhesive disposed along the perimeter of the substrate and the lid, the sealant/adhesive comprising a radiation-curable adhesive/sealant composition comprising:
a) a radiation-curable barrier rubber resin not containing siloxane functionality,
b) a radiation-curable resin diluent
c) a photoinitiating system comprising one or more photoinitiators selected from diaryliodonium salts and triarylsulfonium salts and optionally one or more photosensitizers selected from isopropylthioxanthone (ITX) and chloropropoxythioxanthone (CPTX),, wherein the radiation-curable barrier rubber resin is an olefin-terminal polyisobutylene, polyisobutylene acrylate, polyisobutylene epoxy, polyisobutylene vinyl ether, butyl rubber, and epoxidized butyl rubber, acrylated butyl rubber, maleated butyl rubber or mercaptan functional butyl rubber,
and wherein in a radiation curable resin diluent is bisphenol F diglycidyl ether, bisphenol A diglycidyl ether, tetramethylbiphenyldiglycidyl ether, resorcinol diglycidyl ether, hydrogenated bisphenol A diglycidylether, cyclohexanedimethylol diglycidyl ether, cycloaliphatic epoxy resin, oxetane resin, cyclohexanedimethylol divinyl ether, dodecyl vinyl ether, hexane diol diacrylate, trimethylolpropane triacrylate, cyclohexanedimethylol diacrylate, dicyclo-pentadienedimethylol diacrylate, tris(2-hydroxyethyl)isocyanurate triacrylate, poly(butadiene)dimethacrylate, bisphenol A based acrylated epoxy, maleimide resins have the structures 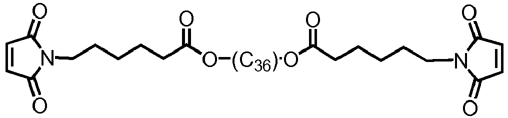 in which (C₃₆) represents a hydrocarbon moiety having 36 carbons, which can be a straight or branched chain, with or without cyclic structures; 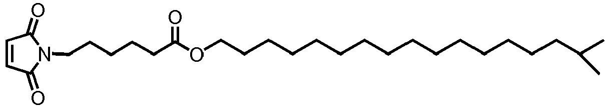 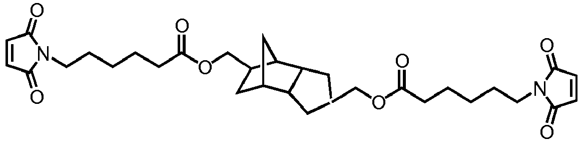 and 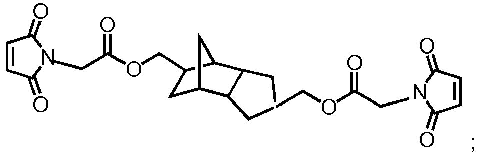 pentaerythritoltetrakis(3-mercaptopropionate)/triallyl-isocyanurate, diallylchlorendate or tetraallylbisphenol A.

3. An electronic or optoelectronic device according to claim 1 in which the device is an electrophoretic device.

4. An electronic or optoelectronic device according to claim 1 or 2 in which the device is an OLED device.

5. An electronic or optoelectronic device according to claim 2 in which the device is an electrophoretic device.

## Patentansprüche

1. Elektronische oder optoelektronische Vorrichtung, angeordnet auf einem Substrat und eingekapselt mit einer Abdeckung, wobei die Abdeckung und das Substrat mit einem Dichtungsmittel/Klebemittel miteinander verbunden sind, das auf der gesamten Fläche zwischen dem Substrat und der Abdeckung angeordnet ist, wobei das Dichtungsmittel/Klebmittel eine strahlungshärtbare Klebmittel/Dichtungsmittel-Zusammensetzung umfasst, die Folgendes umfasst:
a) ein strahlungshärtbares Barriere-Gummi-Kunstharz, das keine Siloxanfunktionalität enthält,
b) einen strahlungshärtbaren Kunstharzverdünner
c) ein photoiniziierendes System, das einen oder mehrere Photoinitiatoren umfasst, ausgewählt aus Diaryliodoniumsalzen und Triarylsufoniumsalzen und gegebenenfalls einem oder mehreren Photosensibilatoren ausgewählt aus Isopropylthioanthon (ITX) und Chloropropoxythioanthon (CPTX), wobei das strahlungshärtbare Barriere-Gummi-Kunstharz ein olefin-terminales Polyisobutylen, Polyisobutylen-Acrylat, Polyisotbutylen-Epoxid, Polyisobutylen-Vinylether, Butylgummi, epoxidiertes Butylgummi, acryliertes Butylgummi, maliertes Butylgummi, oder mercaptan-funktionales Butylgummi ist, und wobei in einem strahlungshärtbarem Kunstharzverdünner Bisphenol-F-Diglycidylether, Bisphenol-A-Diglycidylether, Tetramethylbiphenyl-Diglycidylether, Resorcinol-Diglycidylether, hydrierter Bisphenol-A-Diglycidylether, Cyclohexandimethylol-Diglycidylether, cycloaliphatisches Epoxidharz, Oxetanharz, Cyclohexandimethylol-Divinylether, Dodecyl-Vinylether, Hexandioldiarcrylat, Trimethylolpropantriacrylat, Cyclohexandimethylol-Diacrylat, Dicyclopentadiendimehtyloldiacrylat, tris(2-Hydroxyethyl)isocyanuratetriacrylat, Poly(Butadien)dimethacrylat, bisphenol-A-basiertes acryliertes Epoxid ist, wobei Maleimidharze, die folgenden Strukturen aufweisen: 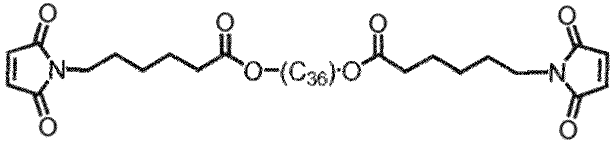 wobei (C₃₆) eine Kohlenwasserstoffgruppe darstellt, die 36 Kohlenstoffe aufweist, die geradkettig oder verzweigtkettig, mit oder ohne zyklischen Strukturen sein kann; 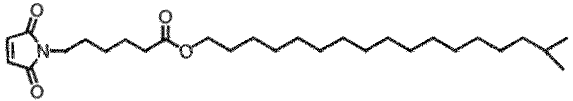 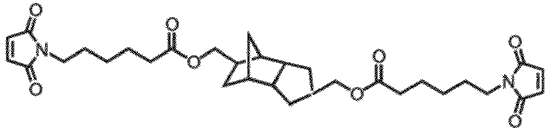 und 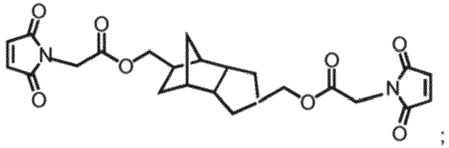 Pentaerythrittetrakis(3-Mercaptopropionat)/Triallylisocyanurat, Diallylchlorentat oder TetraallylBisphenol-A.

2. Elektronische oder optoelektronische Vorrichtung, angeordnet auf einem Substrat und eingekapselt mit einer Abdeckung, wobei die Abdeckung und das Substrat mit einem Dichtungsmittel/Klebmittel miteinander verbunden sind, das entlang des Umfangs des Substrats und der Abdeckung angeordnet ist, wobei das Dichtungsmittel/Klebmittel eine strahlungshärtbare Klebmittel/Dichtungsmittel-Zusammensetzung umfasst, die Folgendes umfasst:
a) ein strahlungshärtbares Barriere-Gummi-Kunstharz, das keine Siloxanfunktionalität enthält,
b) einen strahlungshärtbaren Kunstharzverdünner,
c) ein photoiniziierendes System, das einen oder mehrere Photoinitiatoren umfasst, ausgewählt aus Diaryliodoniumsalzen und Triarylsufoniumsalzen und gegebenenfalls einem oder mehreren Photosensibilatoren ausgewählt aus Isopropylthioanthon (ITX) und Chloropropoxythioanthon (CPTX), wobei das strahlungshärtbare Barriere-Gummi-Kunstharz ein olefin-terminales Polyisobutylen, Polyisobutylen-Acrylat, Polyisotbutylen-Epoxid, Polyisobutylen-Vinylether, Butylgummi und epoxidiertes Butylgummi, acryliertes Butylgummi, maliertes Butylgummi, oder mercaptan-funktionales Butylgummi ist,
und wobei in einem strahlungshärtbaren Kunstharzverdünner Bisphenol-F-Diglycidylether, Bisphenol-A-Diglycidylether, Tetramethylbiphenyl-Diglycidylether, Resorcinol-Diglycidylether, hydrierter Bisphenol-A-Deglycidylether, Cycloheandimethylol-Diglycidylether, cycloaliphatisches Epoxidharz, Oxetanharz, Cyclohexandimethylol-Divinylether, Dodecyl-Vinylether, Hexandioldiacrylat, Trimethylolpropantriacrylat, Cyclohexandimethyloldiacrylat, Dicyclopentadiendimethyloldiacrylat, tris(2-Hydroxyethyl)isocyanuratetriacrylat, Poly(Butadien)dimethacrylat, bisphenol-A-basiertes acryliertes Epoxid ist, wobei Maleimidharze, die folgenden Strukturen aufweisen: 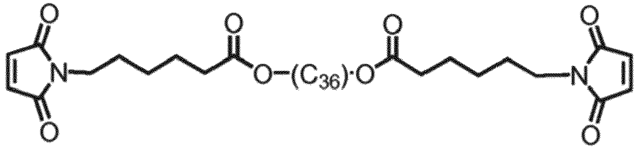 wobei (C₃₆) eine Kohlenwasserstoffgruppe darstellt, die 36 Kohlenstoffe aufweist, die geradkettig oder verzweigtkettig, mit zyklischen Strukturen oder ohne sie sein kann; 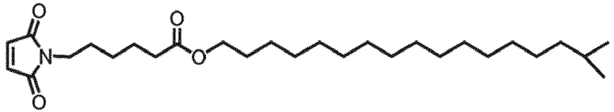 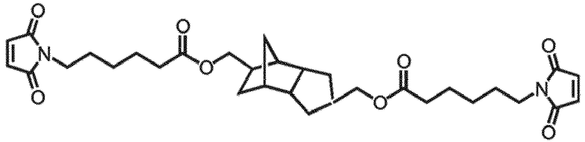 und 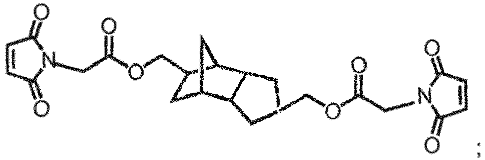 Pentaerythrittetrakis(3-Mercaptopropionat)/Triallylisocyanurat, Diallylchlorentat oder TetraallylBisphenol-A.

3. Elektronische oder optoelektronische Vorrichtung nach Anspruch 1, wobei die Vorrichtung eine elektrophoretische Vorrichtung ist.

4. Elektronische oder optoelektronische Vorrichtung nach Anspruch 1 oder 2, wobei die Vorrichtung eine OLED-Vorrichtung ist.

5. Elektronische oder optoelektronische Vorrichtung nach Anspruch 2, wobei die Vorrichtung eine elektrophoretische Vorrichtung ist.

## Revendications

1. Dispositif électronique ou optoélectronique, disposé sur un substrat et encapsulé avec un couvercle dans lequel le couvercle et le substrat sont liés entre eux par un agent adhésif/d'obturation disposé sur toute la surface entre le substrat et le couvercle, l'agent adhésif/d'obturation comprenant une composition adhésive/d'obturation durcissable par rayonnements comprenant :
a) une résine de caoutchouc à barrière durcissable par rayonnements ne contenant pas de fonctionnalité siloxane,
b) un diluant à base de résine durcissable par rayonnements
c) un système photoamorceur comprenant un ou plusieurs photo-initiateurs sélectionnés parmi des sels de diaryliodonium et des sels de triarysulfonium et éventuellement un ou plusieurs photo-sensibilisateurs sélectionnés parmi l'isopropylthioxanthone (ITX) et le chloropropoxythioxanthone (CPTX), dans lequel la résine de caoutchouc à barrière durcissable par rayonnements est un polyoisobutylène à oléfine terminale, un acrylate de polyisobutylène, un époxy de polyisobutylène, un éther vinylique de polyisobutylène, un caoutchouc butyle, un caoutchouc butyle époxydé, un caoutchouc butyle acrylé, un caoutchouc butyle maléaté ou un caoutchouc fonctionnel mercaptan, et dans lequel dans un diluent à base de résine durcissable par rayonnements est l'éther de diglycidyle de bisphénol F, l'éther de diglycidyle de bisphénol A, l'éther de diglycidyle de tétraméthylbiphényle, l'éther de diglycidyle de résorcinol, l'éther de diglycidyle de bisphénol A hydrogéné, l'éther de diglycidyle de diméthylol-cyclohexane, la résine d'époxy cycloaliphatique, la résine d'oxétane, l'éther de divinyle de diméthylol-cyclohexane, l'éther de vinyle de dodécyle, le diacrylate d'hexanediol, le triacrylate de triméthylolpropane, le diacrylate de diméthylol-cyclohexane, le diacrylate de dicyclopentadiènediméthylol, le tris(2-hydroxyéthyl)isocyanurate-triacrylate, le poly(butadiène)diméthacrylate, l'époxy acrylé à base de bisphénol A, les résines de maléimides ayant les structures 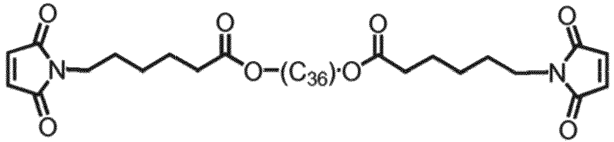 dans lequel (C₃₆) représente un fragment hydrocarboné à 36 atomes de carbones, qui peut être une chaîne linéaire ou ramifiée, avec ou sans structure cyclique ; 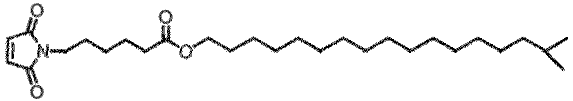 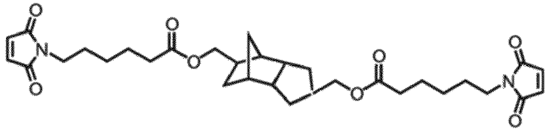 and 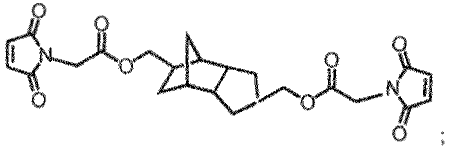 pentaérythritoltétrakis(3-mercaptopropionate)/triallyl-isocyanurate, diallylchlorendate ou tétraallylbisphénol A.

2. Dispositif électronique ou optoélectronique, disposé sur un substrat et encapsulé avec un couvercle dans lequel le couvercle et le substrat sont liés entre eux par un agent adhésif/d'obturation disposé le long du périmètre du substrat et du couvercle, l'agent adhésif/d'obturation comprenant une composition adhésive/d'obturation durcissable par rayonnements comprenant :
a) une résine de caoutchouc à barrière durcissable par rayonnements ne contenant pas de fonctionnalité siloxane,
b) un diluant à base de résine durcissable par rayonnements
c) un système photoamorceur comprenant un ou plusieurs photo-initiateurs sélectionnés parmi des sels de diaryliodonium et des sels de triarysulfonium et éventuellement un ou plusieurs photo-sensibilisateurs sélectionnés parmi l'isopropylthioxanthone (ITX) et le chloropropoxythioxanthone (CPTX), dans lequel la résine de caoutchouc à barrière durcissable par rayonnements est un polyoisobutylène à oléfine terminale, un acrylate de polyisobutène, un époxy de polyisobutylène, un éther vinylique de polyisobutylène, un caoutchouc butyle, un caoutchouc butyle époxydé, un caoutchouc butyle acrylé, un caoutchouc butyle maléaté ou un caoutchouc fonctionnel mercaptan,
et dans lequel dans un diluent à base de résine durcissable par rayonnements est l'éther de diglycidyle de bisphénol F, l'éther de diglycidyle de bisphénol A, l'éther de diglycidyle de tétraméthylbiphényle, l'éther de diglycidyle de résorcinol, l'éther de diglycidyle de bisphénol A hydrogéné, l'éther de diglycidyle de diméthylol-cyclohexane, la résine d'époxy cycloaliphatique, la résine d'oxétane, l'éther de divinyle de diméthylol-cyclohexane, l'éther de vinyle de dodécyle, le diacrylate d'hexanediol, le triacrylate de triméthylolpropane, le diacrylate de diméthylol-cyclohexane, le diacrylate de dicyclopentadiènediméthylol, le tris(2-hydroxyéthyl)isocyanurate-triacrylate, de poly(butadiène)diméthacrylate, l'époxy acrylé à base de bisphénol A, les résines de maléimides ayant les structures 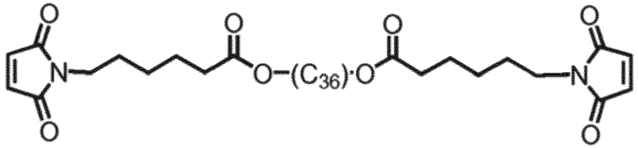 dans lequel (C₃₆) représente un fragment hydrocarboné à 36 atomes de carbones, qui peut être une chaîne linéaire ou ramifiée, avec ou sans structure cyclique ; 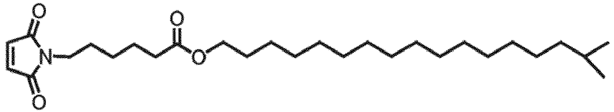 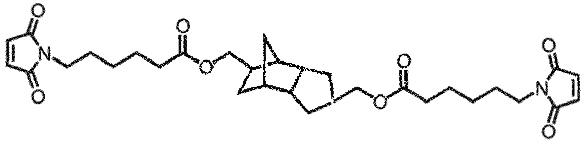 and 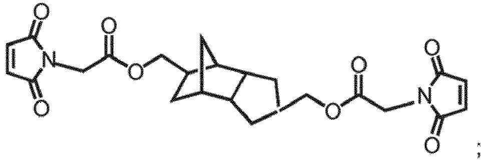 pentaérythritoltétrakis(3-mercaptopropionate)/triallyl-isocyanurate, diallylchlorendate ou tétraallylbisphénol A.

3. Dispositif électronique ou optoélectronique selon la revendication 1, dans lequel le dispositif est un dispositif électrophorétique.

4. Dispositif électronique ou optoélectronique selon la revendication 1 ou 2, dans lequel le dispositif est un dispositif OLED.

5. Dispositif électronique ou optoélectronique selon la revendication 2, dans lequel le dispositif est un dispositif électrophorétique.
